(19) Europäisches Patentamt
European Patent Office
Office européen des brevets

(11) **EP 1 107 420 A2**

(12) **EUROPEAN PATENT APPLICATION**


(43) Date of publication:
**13.06.2001 Bulletin 2001/24**

(51) Int Cl.[7]: **H02J 7/00**

(21) Application number: **00310366.0**

(22) Date of filing: **22.11.2000**

(84) Designated Contracting States:
**AT BE CH CY DE DK ES FI FR GB GR IE IT LI LU MC NL PT SE TR**
Designated Extension States:
**AL LT LV MK RO SI**

(30) Priority: **03.12.1999 KR 9954697**



(71) Applicant: **Onemocall Co., Ltd**
**Dongdaemoon-gu, Seoul 130-814 (KR)**

(72) Inventors:
- **Kim, Jong Chul**
  **Sooji-eup,Yongin city,Kyonggi-do 449-846 (KR)**
- **Lee, Seung Youp**
  **Seoul 121-808 (KR)**

(74) Representative: **Geary, Stuart Lloyd et al**
**Venner, Shipley & Co.,**
**20 Little Britain**
**London EC1A 7DH (GB)**


(54) **Power supply circuit**


(57) A power supply circuit includes two power storage devices (50, 80), one of which is better at supplying current in pulses. Switching ($SW_3$, $SW_4$) and control means (61) are arranged so that current is usually supplied from the power storage device (80) which is better at supplying pulsed current but both power storage devices (50, 80) are used when the voltage across the usually employed power storage device (80) falls below a threshold, e.g. during periods of relatively high current demand.


FIG. 3

BATTERY
SW5
EDLC1
SW3
LOAD
SW4
SWITCHING CONTROLLER
INTERNAL SWITCHING MODULE
VOLTAGE SENSOR
SW1
SW2
EDLC2
PROTECTIVE CIRCUIT
EXTERNAL POWER SUPPLY
56
53
40
55
90
54
61
70
50
57
52
80
51
62
30
58
63
60
: POWER SUPPLY LINE
: CONTROL LINE
: SENSING LINE





Printed by Jouve, 75001 PARIS (FR)

## Description

The present invention relates to a power supply circuit comprising a first power storage device.

Recently, in accordance with technological innovation, small-sized and light-weight portable electronic devices have gained widespread popularity. The portable electronic devices include mobile communication devices such as cellular phones, notebook type computers, camcorders, MP3 and the like.

Most of portable electronic devices are generally powered by a packaged battery (to be referred to as a battery pack hereinafter). A portable electronic device having a built-in battery pack is operable even at a place where a commercial power supply is not available.

Typically, rechargeable (secondary) batteries that can be recycled by charging, such as nickel cadmium (NiCd), nickel metal hydride (NiMH), or lithium ion (Li-ion) batteries, are used as the built-in battery of a portable electronic device. The built-in battery is charged by external AC power in a state that a battery pack is mounted in a system, i.e., a portable electronic device.

Also, a feature of the portable electronic device is to include a digital load made up of digital circuits.

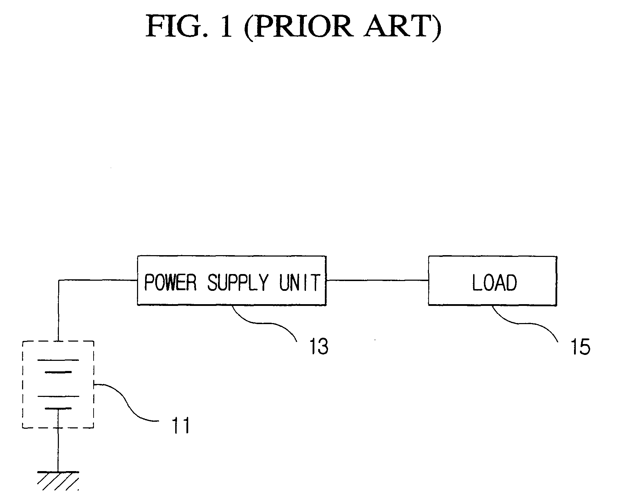

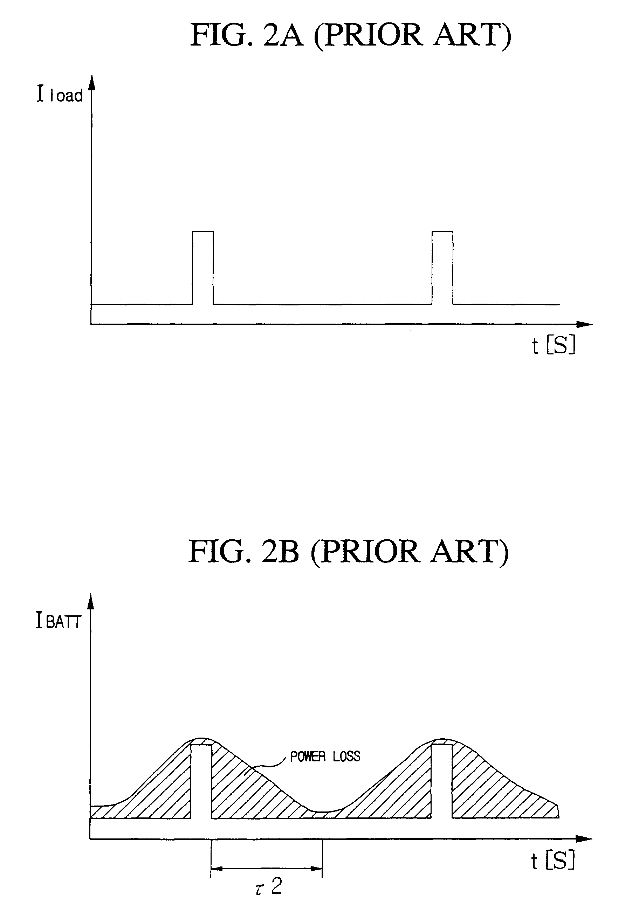

Figure 1 shows a power supply system of a portable electronic device having a digital load. As shown in Figure 1, a power supply unit 13 for supplying power to various parts of the portable electronic device is interposed between a rechargeable battery 11 and a load 15. Here, the load 15 is a digital load and requires pulse-like power shown in Figure 2A.

In other words, the digital load consumes current such that pulse waves are generated in units of a predetermined cycle. However, since currently available rechargeable (secondary) batteries have a difficulty in rapidly discharging, they cannot follow a pulse-like current characteristic rapidly, as shown in Figure 2B.

Accordingly, a digital load using a rechargeable battery as a power supply gives rise to unnecessary current consumption, as indicated by hatched portions in Figure 2B.

As described above, in the conventional power supply system having a digital load, since a battery cannot rapidly follow a current consumption characteristic of a load, the power utilization efficiency is extremely low.

The present inventors have found out that the power consumption of a power supply system is increased and the power utilization efficiency is lowered in the case of using conventional primary and secondary batteries as a main power supply of a digital load requesting periodic pulse power (to be abbreviated as "pulse power").

Also, in the case of using only a power storage device capable of rapidly discharging as a main power supply in order to rapidly follow the pulse power, a sharp voltage drop due to system overload is unavoidable.

Therefore, the present inventors have proposed a method in which while using a power storage device capable of rapidly discharging as a main power supply of a digital load, a conventional battery is used as an auxiliary power supply for the purpose of preventing a sharp voltage drop occurring at the power storage device in the event of system overload.

A power supply circuit according to the present invention is characterised by a second power storage device, switching means and control means, wherein the second power storage device has a better ability to supply pulsed current to a load than the first power storage means and the control means is operable to sense the voltage across the second power storage device and control the switching means in response thereto such that when said sensed voltage is above a threshold, power to supplied by the circuit from the second power storage device only and otherwise from both the first and second power storage devices.

Preferably, the first power storage device is a battery and the second power storage device is a an electrolytic double layer capacitor.

Also according to the present invention, there is provided a power supply controller connected to a digital variable load requesting periodic pulse power, for controlling power supplied to the digital variable load, the power supply controller including a first power storage device as a main power supply, for supplying the periodic pulse power to the variable load, the first power storage device capable of rapidly discharging to rapidly follow the periodic pulse power of the variable load; a second power storage device for supplying the first power storage device with the power for compensating for a voltage drop when a sharp voltage drop occurs to the first power storage device due to overload; a plurality of power supply lines disposed between the first and second power storage devices; and a control unit for sensing an output voltage of the first power storage device and controlling to open and closed states of the plurality of power supply lines to supply the second power storage device with the power stored in the second power storage device if the sensed voltage is dropped to a reference voltage level or below. Thus, only the first power storage device is discharged under normal load conditions and both the first and second power storage device are discharged in the event of overload.

The first power storage device is preferably an electrolytic double layer capacitor (EDLC) and the second power storage device is preferably either a rechargeable secondary battery or a primary battery.

Also, one or more power supply lines may be disposed between the first power storage device and the second power storage device, and one or more switching elements may be installed along the power supply lines. Also, the control unit connects the first power storage device and the second power storage device by performing switching control of the switching elements.

In particular, the first and second power supply lines may be disposed between the first power storage device and the second power storage device, the first power supply line may directly connect the first power storage device and the second power storage device, and the second power supply line may connect the first power storage device and the second power storage device through an internal switching module of the control unit. In this case, since a larger amount of current flows in the first power supply line than in the second power supply line, it is possible to appropriately cope with the magnitude of a load.

Also, the power supply controller according to the present invention may further include a third power storage device for storing emergency power to be supplied to the second power storage device when the load requests emergency power in a state where the first and second power storage devices are completely discharged.

Here, the third power storage device for storing emergency power is an EDLC having a smaller capacity than the first power storage device and is connected to the second power storage device through switching elements.

According to another aspect of the present invention, in a power supply controller having a digital variable load requesting periodic pulse power, a first power storage device which rapidly follows the periodic pulse power of the variable load, a second power storage device for supplying the first power storage device with compensation power, and first and second power supply lines disposed between the first and second power storage devices, the power supply controlling method therefor includes the steps of sensing the voltage level of the second power storage device and connecting the second power storage device with an external power supply if the sensed voltage level is lowered to a level in which charging is required, sensing the voltage level of the first power storage device and determining whether there is a voltage drop in the first power storage device, if it is determined in the determining step that there is a voltage drop in the first power storage device, determining a voltage drop value, and charging either the first power supply line or the second power supply line based on the determined voltage drop value and compensating for the voltage drop of the first power storage device.

Additional objects and advantages of the present invention will be set fourth in the description which follows, and in part will be obvious from the description, or may be learned by practice of the invention.

By means of embodiments of the present invention, a power supply can be provided which quickly adapts to a power characteristic of a digital load.

Embodiments of the present invention can provide a power supply controller and a power supply controlling method therefor, by which a sharp voltage drop which is an impediment to stable power supply can be prevented, and by which emergency power supply is allowed even in a state that a main power supply is completely discharged.

An embodiment of the present invention will now be described, by way of example, with reference to Figures 2A to 6 of the accompanying drawings, in which: -

Figure 1 is a schematic block diagram of a conventional power supply system;

Figure 2A and Figure 2B show the relationship between a current consumption characteristic and time in a conventional power supply system, in which Figure 2A shows a current consumption of a digital load, and Figure 2B shows a current consumption characteristic of a battery;

Figure 3 is a block diagram showing the overall arrangement of a power supply controller according to the present invention;

Figures 4A and Figure 4B show the relationship between a current consumption characteristic and time in a power supply system according to the present invention, in which Figure 4A shows the current consumption of a digital load, and Figure 4B shows the current consumption characteristic of a main power supply;

Figures 5A and Figure 5B show an overload arising when a digital electronic device is switched from a standby mode to an operation mode, in which Figure 5A shows a severe overload condition occurring to a load, and Figure 5B shows a sharp voltage drop occurring to a main power supply in the event of an overload; and

Figure 6 is a flow diagram of a procedure of determining the optimal power to be supplied to a load on the basis of a variation in the load, in a power supply controller according to the present invention.

Before going any further, it is to be noted that any terms or words used in the present specifications and claims should not be taken in a limited way and interpreted ordinarily and lexicographically, but interpreted in the sense and concept that go with the technical thoughts of the present invention, based on the principle that an inventor is authorized to define a term appropriately in order to explain his or her invention in the best possible way. Accordingly, the embodiment described in the specifications herein and the composition illustrated in the drawings herein are nothing more than an embodiment deemed most desirable, and do not represent the whole technical thoughts of the present invention, allowing for the possibility of a variety of equivalents that can replace the embodiments provided herein and variant examples.

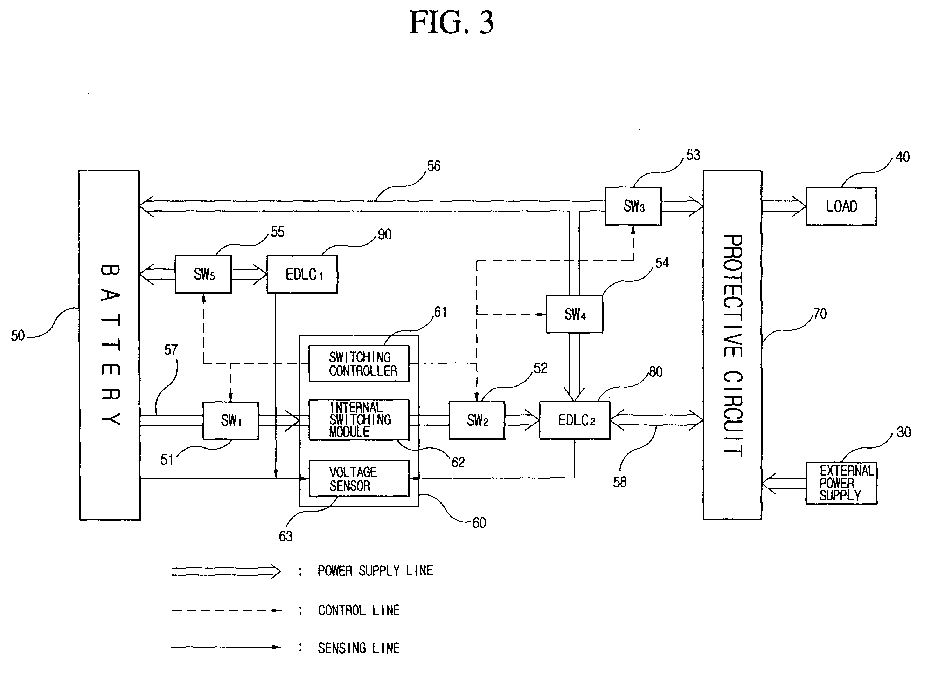

Referring to Figure 3 showing the overall arrangement of a power supply controller according to the present invention, the power supply controller includes a battery 50, a control unit 60, a protective circuit 70, a first electrolytic double layer capacitor (EDLC1) 90, a second electric double layer capacitor (EDLC2) 80 and a plurality of switching elements 51, 52, 53, 54 and 55.

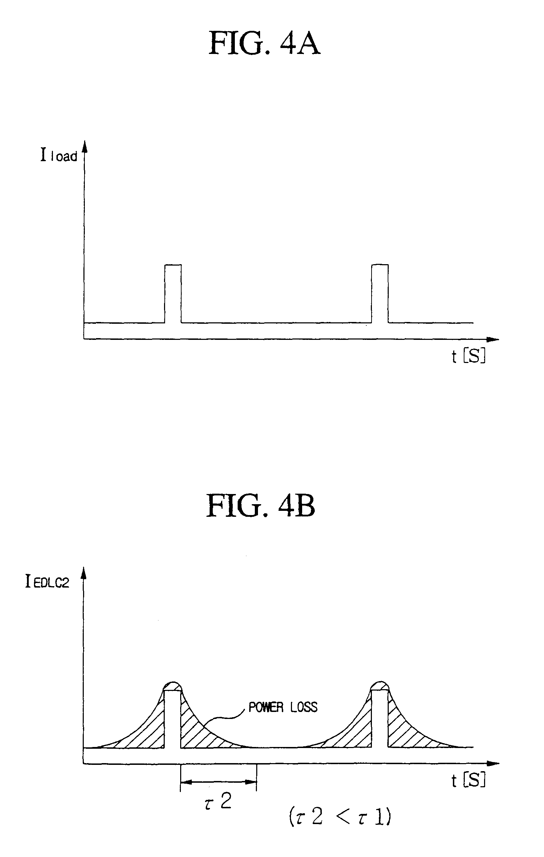

A digital variable load 40 having a current consumption characteristic shown in Figure 4A and an external power supply 30 such as a commercial AC power supply are connected to the protective circuit 70.

The battery 50 is a kind of a power storage device for storing electrical energy and discharging, and a primary battery, a rechargeable secondary battery, a solar battery and the like can be used as the battery 50. In this embodiment, a rechargeable secondary battery is used as the battery 50.

The EDLC2 80 is also a kind of a power storage device and is capable of rapidly charging and discharging compared to primary and secondary batteries. Thus, the EDLC2 80 is suitably used as a main power supply of a digital load requesting pulse-like power.

Also, the EDLC1 90 is the same as the EDLC2 80, except for its capacitance. However, since the capacitance of the EDLC1 90 is smaller than that of the battery 50 or the EDLC2 80, the EDLC1 90 is used for emergency power supply in this embodiment.

The control unit 60 includes a voltage sensor 63 for sensing the voltage levels of the battery 50, the EDLC1 90 and the EDLC2 80, a switching controller 61 for controlling the turn-on and turn-off of the plurality of switching elements (SW1, SW2, SW3, SW4 and SW5) 51, 52, 53, 54 and 55, and an internal switching module 62.

The switching elements 51 through 55 switch a power supply line from an open state to a closed state in accordance with a switching control signal of the switching controller 61. The switching elements 51 through 55 are preferably constituted by semiconductor devices such as metal-oxide semiconductor-field effect transistors (MOS-FETs) that consume a relatively small amount of power.

The protective circuit 70 protects a power storage device from over-charging or over-discharging caused during charging or discharging of the EDLC1 or EDLC2. In particular, in the case where a Li-ion battery is used in the present invention, the protective circuit 70 is essentially needed. However, according to the kind of the battery used in the present invention, the protective circuit 70 may not be used.

The load 40 is a digital load incorporated in a portable electronic device and, in particular, is a variable load having a pulse power characteristic shown in Figure 4A.

The external power supply 30 generally implies a commercial AC power supply. The commercial AC power supply also includes an self-generator disclosed in Korean Patent Application Nos. 98-43924 and 99-43024 filed by the present inventors.

As shown in Figure 3, the battery 50 and the EDLC2 80 are connected to each other by first and second power supply lines 56 and 57. The power supply lines 56 and 57 include each two switching elements. The switching elements (SW3 and SW4) 53 and 54 are installed along the first power supply line 56 and the switching elements (SW1 and SW2) 51 and 52 are installed along the second power supply line 57.

Also, the control unit 60 is disposed between the switching elements (SW1 and SW2) 51 and 52 of the second power supply line 57. The second power supply line 57 connects the battery 50 and the EDLC2 80 via its two switching elements (SW1 and SW2) 51 and 52 and the internal switching module 62 of the control unit 60.

The internal switching module 62 of the control unit 60 serves to limit the current discharged by the battery 50 to the predetermined critical value. Thus, the current flowing in the second power supply line 57 has a limited magnitude compared to the current flowing in the first power supply line 56.

The switching element (SW4) 54 of the first power supply line 56 is disposed between the battery 50 and the EDLC2 80, and the switching element (SW3) 53 is disposed between the battery 50 and the protective circuit 70.

Also, the EDLC1 90 which is a spare power supply for supplying emergency power, is connected to the battery 50 through the switching element (SW5) 55. Thus, even if the battery 50 and the EDLC2 80, which serve as a main power supply, are completely discharged, emergency power requested by the load 40 can be supplied. The plurality of switching elements 51 through 55 are controlled by the switching controller 61 of the control unit 60, as indicated by dotted lines in Figure 3, that is, control lines. Also, the voltage sensor 63 of the control unit 60 checks the voltage levels of the power storage devices 50, 80 and 90 at times through sensing lines indicated by solid lines in Figure 3.

The power discharged from the battery 50, the EDLC1 90 and the EDLC2 80 or charged from the external power supply 30 are supplied through the power supply lines 56, 57 and 58 shown in Figure 3.

The operation of the aforementioned power supply controller according to the present invention will now be described in detail. The off-state of a switching element refers to the open state of a power supply line.

If the digital variable load 40 requests pulse power shown in Figure 4A in a state where all the switching elements 51 through 55 are turned off, that is, under general load conditions, the EDLC2 80 capable of rapidly discharging, discharges the current $I_{EDLC2}$ rapidly following the pulse power of the variable load 40, as shown in Figure 4B.

In Figures 2B and 4B, it is understood that the EDLC2 80 follows the pulse power better than the conventional battery. This is easily appreciated from the fact that $\tau_2$ of Figure 4 is much smaller than $\tau_1$ of Figure 2. Thus, in the case of using EDLC as a main power supply for a digital load requesting pulse power, the power consumption can be minimized, unlike in the conventional battery.

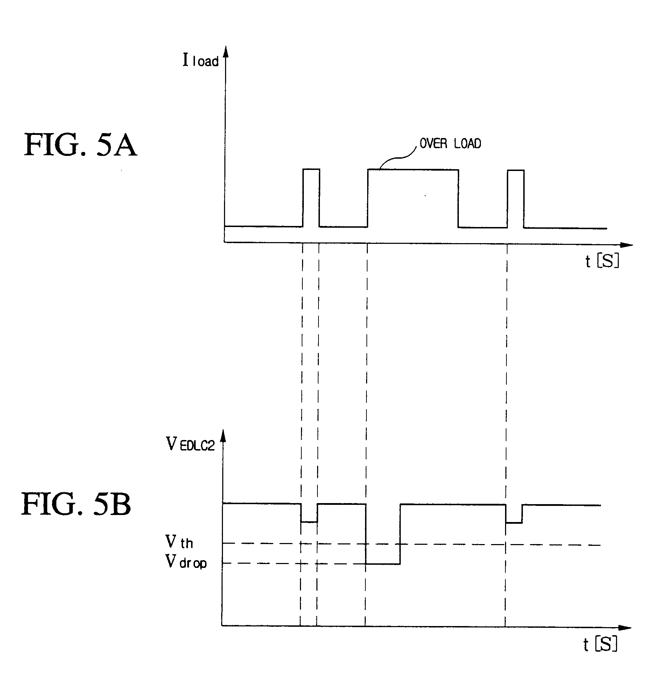

In an overload condition shown in Figure 5A, in which the load 40 abruptly requests a high-level current, a sharp voltage drop occurs to the EDLC2 80, as shown in Figure 5B. In particular, if the voltage drop $V_{drop}$ is lower than a threshold voltage value $V_{th}$, a serious problem may be caused to the power supply system.

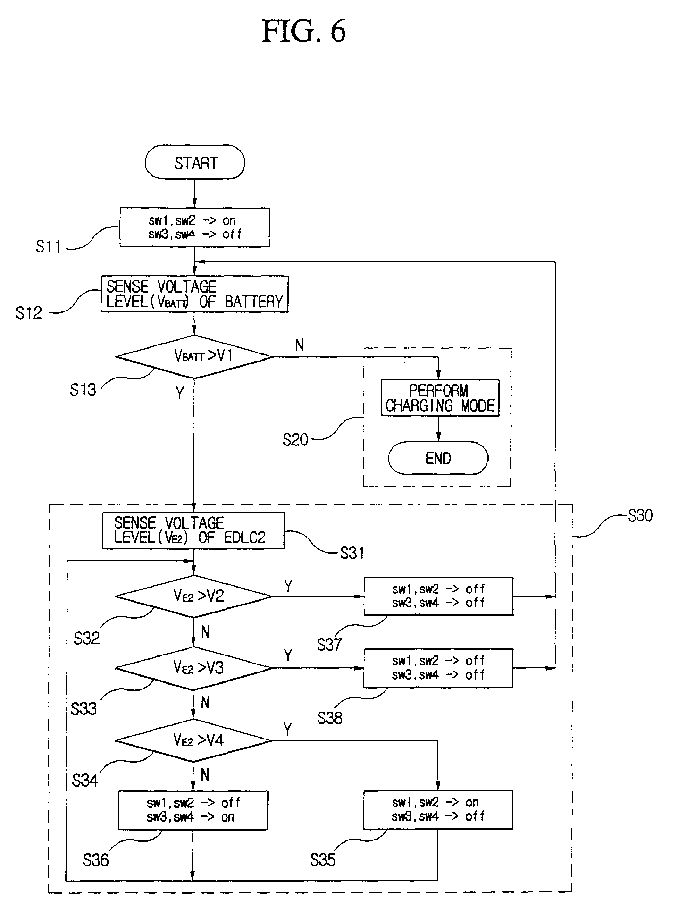

Thus, the control unit 60 of the present invention compensates for a sharp voltage drop occurring to the main power supply, that is, the EDLC2, through the procedure shown in Figure 6.

Now, the procedure in which optimal power is supplied by the control unit 60 of the present invention according to a variation of the load will be described in detail with reference to Figure 6. For a better understanding of the invention, terms shown in Figure 6 will be briefly defined as follows.

$V_{BATT}$ denotes an output voltage of the battery 50, $V_{E2}$ denotes an output voltage of the EDLC2 80, and $V_1$, $V_2$, $V_3$ and $V_4$ denote reference voltages stored in an internal memory (not shown) of the control unit 60. The reference voltages may change variably according to the kind of the load.

In Figure 6, the procedure for the control unit 60 to perform switching control is largely divided into a charging mode performing step (step S20) and a discharging mode performing step (step S30).

At an initial stage for performing switching control, the switching elements (SW1 and SW2) 51 and 52 are turned on, while the switching elements (SW3 and SW4) 53 and 54 are turned off (step S11).

In this state, the voltage sensor 63 of the control unit 60 senses the voltage level $V_{BATT}$ of the battery 50 (step S12). The sensed voltage level $V_{BATT}$ is compared with the reference voltage $V_1$, for example, 3.0 V in the case of a cellular phone (step S13).

A.Charging mode

In the step S13, if the voltage level $V_{BATT}$ of the battery 50 is lower than the reference voltage $V_1$, the control unit 60 charges the battery 50 such that the switching element (SW3) 53 is turned on and the other switching elements (SW1, SW2, SW4 and SW5) 51, 52, 54 and 55 are kept off (step S20).

If the voltage level $V_{BATT}$ of the battery 50 is higher than the reference voltage $V_1$ in the step S13, it is determined that the battery 50 is fully charged to proceed to the discharging mode performing step followed by the step S30.

B. Discharging mode

The control unit 60 senses the voltage $V_{E2}$ of the EDLC2 80 to execute the discharging mode control operation (step S31).

Here, if the reference voltages satisfy that $V_2 > V_3 > V_4$, the switching control operation performed by the control unit 60 is largely divided into the following cases according to a variation of the load.

$$V_{E2} > V_2$$

If the voltage level $V_{E2}$ of the EDLC2 80, sensed in the step S31, is higher than the reference voltage $V_2$, for example, 3.8 V in the case of a cellular phone, the control unit 60 determines that the present state is a normal discharging mode in which there is no voltage drop (step S32). Thus, the switching controller 61 of the control unit 60 turns off all the switching elements (SW1, SW2, SW3, SW4 and SW5) 51, 52, 53, 54 and 55 (step S37), and then the routine goes back to the step S12. (ii) $V_3 < V_{E2} < V_2$

If the voltage level $V_{E2}$ of the EDLC2 80, sensed in the step S31, is lower than the reference voltage $V_2$, and higher than the reference voltage $V_3$, for example, 3.1 V in the case of a cellular phone, the control unit 60 determines that sufficient power can be supplied to the load 40 by using only the ELDC 2 80 even if there is a small amount of a voltage drop in the EDLC2 80 (step S33). Thus, the switching controller 61 of the control unit 60 turns off all the switching elements (SW1, SW2, SW3, SW4 and SW5) 51, 52, 53, 54 and 55 (step S387), and then the routine goes back to the step S12. (iii) $V_4 < V_{E2} < V_3$

If the voltage level $V_{E2}$ of the EDLC2 80, sensed in the step S31, is lower than the reference voltage $V_3$, and higher than the reference voltage $V_4$, for example, 3.05 V in the case of a cellular phone, the control unit 60 determines that there is a little voltage drop in the EDLC2 80 due to overload (step S34). Thus, the switching controller 61 of the control unit 60 turns on the switching elements (SW1 and SW2) 51 and 52 and turns off the switching elements (SW3 and SW4) 53 and 54 to open the first power supply line 57 (step S35). (iv) $V_{E2} < V_4$

If the voltage level $V_{E2}$ of the EDLC2 80, sensed in the step S31, is lower than the reference voltage $V_4$, for example, 3.05 V in the case of a cellular phone, the control unit 60 determines that there is suddenly a large voltage drop in the EDLC2 80 due to severe overloads (step S34). Thus, the switching controller 61 of the control unit 60 turns off the switching elements (SW1 and SW2) 51 and 52 and turns on the switching elements (SW3 and SW4) 53 and 54 to open the second power supply line 57 (step S36).

Since the upper limit of the battery discharged current supplied through the first power supply line 57 is limited to a predetermined critical value through the internal switching module 62 of the control unit 60, the battery discharged current is smaller than the current supplied through the second power supply line 56.

Therefore, if there is a gentle voltage drop in the EDLC2 80, the control unit 60 opens the first power supply line 57. If there is a sharp voltage drop in the EDLC2 80, the control unit 60 opens the second power supply line 56. In such a manner, the problem of a system, which may be caused due to a voltage drop, can be overcome.

The power supply controller and the power supply controlling method according to the present invention allow a digital load to rapidly follow periodic pulse power. Also, according to the present invention, it is possible to effectively cope with a voltage drop occurring at a main power supply, which is caused due to a variation in the load. In particular, according to the present invention, the power utilization efficiency can be maximized by adjusting the magnitude of the current discharged by a battery according to either a gentle voltage drop or a sharp voltage drop. Further, the present invention enables emergency power supply requested by a load, even if EDLCs and a battery, serving as a main power supply, are completely discharged.

The present invention can be applied to power supply systems for portable digital electronic devices which are driven by a battery, such as cellular phones, notebook computers, camcorders, MP3 or the like.

The present invention is not limited to the above-described embodiment and various modifications and changes will readily occur to those skilled in the art within the spirit or scope of the present invention as defined by the appended claims and their equivalents.

## Claims

1. A power supply circuit comprising a first power storage device (50), **characterised by** a second power storage device (80), switching means ($SW_3$, $SW_4$) and control means (61), wherein the second power storage device (80) has a better ability to supply pulsed current to a load than the first power storage means (50) and the control means (61) is operable to sense the voltage across the second power storage device (80) and control the switching means ($SW_3$, $SW_4$) in response thereto such that when said sensed voltage is above a threshold, power to supplied by the circuit from the second power storage device (80) only and otherwise from both the first and second power storage devices (50, 80).

2. A circuit according to claim 1, wherein the first power storage device (50) is a battery and the second power storage device (50) is a an electrolytic double layer capacitor.

3. A power supply controller connected to a digital variable load requesting periodic pulse power, for controlling power supplied to the digital variable load, the power supply controller comprising:

   a first power storage device as a main power supply, for supplying the periodic pulse power to the variable load, the first power storage device capable of rapidly discharging to rapidly follow the periodic pulse power of the variable load;

   a second power storage device for supplying the first power storage device with the power for compensating for a voltage drop when a sharp voltage drop occurs to the first power storage device due to overload;

   a plurality of power supply lines disposed between the first and second power storage devices; and

   a control unit for sensing an output voltage of the first power storage device and controlling open and closed states of the plurality of power supply lines to supply the second power storage device with the power stored in the second power storage device when the sensed voltage is dropped to a reference voltage level or below, whereby only the first power storage device is discharged under normal load conditions and both the first and second power storage device are discharged in the event of overload.

4. The power supply controller according to claim 3, wherein the first power storage device is an electric double layer capacitor (EDLC) and the second power storage device is either a rechargeable secondary battery or a primary battery.

5. The power supply controller according to claim 4, wherein one or more power supply lines are disposed between the first power storage device and the second power storage device, one or more switching elements are installed along the power supply lines, and the control unit connects the first power storage device and the second power storage device by performing switching control of the switching elements.

6. The power supply controller according to claim 5, wherein first and second power supply lines are disposed between the first power storage device and the second power storage device, the first power supply line directly connecting the first power storage device and the second power storage device, the second power supply line connecting the first power storage device and the second power storage device through the control unit, and the control unit controlling a larger amount of current to flow through the first power supply line than through the second power supply line by limiting the upper limit value of the current flowing therein to a predetermined critical value.

7. The power supply controller according to claim 6, wherein one or more switching elements are included in the first and second power supply lines.

**8.** The power supply controller according to claim 7, wherein the control unit comprises:

a switching controller for controlling the switching elements installed in the first and second power supply lines;
a voltage sensor for sensing the voltage levels of the first and second power storage devices; and
an internal switching module for limiting the upper limit value of the current flowing through the second power supply line.

**9.** The power supply controller according to claim 3, further comprising a third power storage device for storing emergency power to be supplied to the second power storage device when the load requests emergency power in a state where the first and second power storage devices are completely discharged.

**10.** The power supply controller according to claim 9, wherein the third power storage device for storing emergency power is an EDLC having a smaller capacity than the first power storage device and is connected to the second power storage device through switching elements.

**11.** The power supply controller according to claim 10, wherein the control unit senses the voltage levels of the first and second power storage devices, and turns on the switching elements to supply the power of the third power storage device to the second power storage device when emergency power supply is requested by the load in a state where the first and second power storage devices are completely discharged.

**12.** A power supply controlling method for a power supply controller having a digital variable load requesting periodic pulse power, a first power storage device which rapidly follows the periodic pulse power of the variable load, a second power storage device for supplying the first power storage device with compensation power, and first and second power supply lines disposed between the first and second power storage devices, the power supply controlling method comprising the steps of:

sensing the voltage level of the second power storage device and connecting the second power storage device with an external power supply when the sensed voltage level is lowered to a level in which charging is required;
sensing the voltage level of the first power storage device and determining whether there is a voltage drop in the first power storage device;
determining a voltage drop value, when there is a voltage drop in the first power storage device; and
charging the first power storage device by opening the selected one of the first power supply line and the second power supply line based on the determined voltage drop value and compensating for the voltage drop of the first power storage device.

**13.** The power supply controlling method according to claim 12, wherein the compensation current flowing through the first power supply line is larger than that flowing through the second power supply line.

# FIG. 1 (PRIOR ART)

POWER SUPPLY UNIT
LOAD
13
15
11

# FIG. 2A (PRIOR ART)

I load
t [S]

# FIG. 2B (PRIOR ART)

IBATT
POWER LOSS
t [S]
τ 2

FIG. 3

LOAD
EXTERNAL POWER SUPPLY
PROTECTIVE CIRCUIT
SW3
SW4
EDLC2
SW2
SWITCHING CONTROLLER
INTERNAL SWITCHING MODULE
VOLTAGE SENSOR
EDLC1
SW5
SW1
BATTERY
: POWER SUPPLY LINE
: CONTROL LINE
: SENSING LINE
40
30
70
53
54
80
58
52
60
61
62
63
56
90
55
57
51
50

FIG. 4A

I load
t [S]

FIG. 4B

I EDLC2
POWER LOSS
t [S]
τ 2
(τ 2 < τ 1)

FIG. 5A
I load
OVER LOAD
t [S]
FIG. 5B
V EDLC2
V th
V drop
t [S]

# FIG. 6

START
sw1,sw2 -> on
sw3,sw4 -> off
S11
SENSE VOLTAGE
LEVEL(VBATT) OF BATTERY
S12
VBATT >V1
S13
N
Y
PERFORM
CHARGING MODE
END
S20
S30
SENSE VOLTAGE
LEVEL(VE2) OF EDLC2
S31
VE2 >V2
S32
Y
N
sw1,sw2 -> off
sw3,sw4 -> off
S37
VE2 >V3
S33
Y
N
sw1,sw2 -> off
sw3,sw4 -> off
S38
VE2 >V4
S34
Y
N
sw1,sw2 -> off
sw3,sw4 -> on
S36
sw1,sw2 -> on
sw3,sw4 -> off
S35